# EUROPÄISCHE PATENTSCHRIFT

(11) **EP 1 851 367 B1**
(45) Veröffentlichungstag und Bekanntmachung des Hinweises auf die Patenterteilung: **08.08.2012**
(21) Anmeldenummer: 06706634.0
(22) Anmeldetag: 03.02.2006
(51) Int. Cl.: C30B 11/00

(54) **VERFAHREN UND VORRICHTUNG ZUM HERSTELLEN GERICHTET ERSTARRTER BLÖCKE AUS HALBLEITERMATERIALIEN**
METHOD AND DEVICE FOR PRODUCING ORIENTED SOLIDIFIED BLOCKS MADE OF SEMI-CONDUCTOR MATERIAL
PROCEDE ET DISPOSITIF POUR REALISER DES BLOCS SOLIDIFIES DE FAÇON ORIENTEE A PARTIR DE MATERIAUX SEMI-CONDUCTEURS

(30) Priorität: 03.02.2005 DE 102005005182
(43) Veröffentlichungstag der Anmeldung: 07.11.2007
(73) Patentinhaber: Rec Scanwafer AS, 3908 Porsgrunn (NO)
(72) Erfinder: HUGO, Franz, 63743 Aschaffenburg (DE)
(74) Vertreter: Grünecker, Kinkeldey, Stockmair & Schwanhäusser
(86) Internationale Anmeldenummer: PCT/EP2006/000972
(87) Internationale Veröffentlichungsnummer: WO 2006/082085

(56) Entgegenhaltungen:
- EP-A- 1 072 696
- EP-A1- 1 048 758
- DE-A1- 2 332 388
- DE-A1- 19 855 061
- US-A- 5 988 257

## Beschreibung

Die Erfindung betrifft ein Verfahren zum Herstellen gerichtet erstarrter Blöcke aus Halbleitermaterialien, nach dem Oberbegriff des Anspruchs 1, sowie eine entsprechende Vorrichtung nach dem Oberbegriff des Anspruchs 3.

Mit Verfahren und Vorrichtungen nach dem Stand der Technik zum Herstellen von gerichtet erstarrten Blöcken aus Halbleitermaterialien, insbesondere von gerichtet erstarrtem Silizium, wird die Schmelze, in einem Tiegel aufgenommen, entweder von der Seite oder von der Oberseite aus beheizt. Das Beheizen von oben hat den Vorteil, dass eine gute horizontale Energieverteilung erreicht wird, was zu der angestrebten horizontalen Phasengrenze beim Erstarren führt. Der Nachteil ist jedoch, dass sich das Heizelement direkt im Dampfstrom des während der Erstarrung flüssig gehaltenen Halbleitermaterials befindet und deshalb mit dem Halbleitermaterial, beispielsweise Silizium, reagiert. Bei den nach dem Stand der Technik üblicherweise eingesetzten Heizelementen aus Graphit führt dies zu einer schnellen Alterung und auch zu einer Änderung des elektrischen Widerstands mit den entsprechende Folgen.

Die Offenlegungsschrift EP 1 048 758 A1 beschreibt ein Verfahren und eine Vorrichtung mit den Merkmalen des Oberbegriffs des Anspruchs 1 bzw. 3.

Die Offenlegungsschrift DE 23 32 388 A1 beschreibt ein Verfahren zur Herstellung stabförmiger Einkristalle, wobei das Ausgangsmaterial in einem Tiegel innerhalb einer rohrförmigen Kammer erhitzt wird. Die Kammer befindet sich zu diesem Zweck in einem Ofen und ist teilweise von wannenförmigen Erhitzungselementen umgeben.

Aufgabe der vorliegenden Erfindung ist es, ein Verfahren und eine Vorrichtung zum Herstellen gerichtet erstarrter Blöcke, d.h. zum Durchführen eines Kristallisationsverfahrens, zu schaffen, die insbesondere die Alterung der Heizelemente durch den Einfluss des Metalldampfes vermeiden, und darüber hinaus die Möglichkeit bieten, definiert und reproduzierbar die Schmelze beheizen zu können.

Gelöst wird die Aufgabe durch ein Verfahren mit den im Kennzeichen des Anspruchs 1 definierten Merkmalen.

Vorrichtungsgemäß wird die Aufgabe gelöst durch eine Vorrichtung mit den im Kennzeitchen des Anspruchs 3 definierten Merkmalen.

Dieses Verfahren sowie diese Vorrichtung zeichnen sich dadurch aus, dass kein unmittelbarer Kontakt zwischen dem von der Metallschmelze abgegebenen Metalldampf und den Heizelementen auftritt.

Vorzugsweise kann das Verfahren so durchgeführt werden, dass der Tiegel zumindest von der Oberseite aus über die obere Heizkammer und den Prozessraum zum gerichteten Erstarren, unter Ausnutzung der Kristallisation, erwärmt wird, ohne dass die oberen Heizelemente beeinträchtigt werden.

In Verbindung mit der erfindungsgemäßen Vorrichtung wird das Verfahren derart durchgeführt, dass über eine Zwischendecke oberhalb des Tiegels und damit oberhalb der Schmelze die obere Heizeinrichtung gasdicht getrennt ist, so dass der von der beheizten Schmelze aufsteigende Metalldampf, beispielsweise der Siliziumdampf, von diesem aktiven Heizelement ferngehalten wird.

Bevorzugt sind auch Maßnahmen vorgesehen, dass das oberhalb der Schmelze in dem Prozessraum entstehende Gas so abgeführt wird, dass es nicht in die Heizkammer gelangt.

Darüber hinaus wird vorzugsweise, um die angestrebten Ziele zu erreichen, die Zwischendecke auf einen Rahmen aufgelegt; ein solcher Rahmen umgibt den Tiegel seitlich mit Abstand. Ein solcher Rahmen sollte aus einem isolierenden Material gefertigt sein und sollte, in Bezug auf die Außenisolation, Zwischenisolationswände bilden, das bedeutet, dass die Außenisolation die Zwischenisolationswände mit Abstand, einen Zwischenraum bildend, umgibt. ,

Der Tiegel wird auf einer Trageplatte getragen, die, in einer weiteren Ausgestaltung der Vorrichtung, an ihren Randbereichen eine Umrandung als Teil eines Passepartouts aufweist; mit dieser Umrandung des Passepartouts ist die Trageplatte gegenüber der Zwischenisolation im wesentlichen gasdicht abdichtet.

Der gesamte Tiegel mit Isolierung wird in einer Vakuumkammer angeordnet.

Der Rahmen des Passepartouts, der die Tiegel-Tragplatte seitlich umgibt, bildet gleichzeitig eine Auffangwanne oder einen Teil einer Auffangwanne für eventuell aus dem Tiegel auslaufende Schmelze. In Bezug auf eine solche Auffangwanne kann der Rahmen, der den Tiegel seitlich umgibt, die Seitenwände der Auffangwanne bilden. Weiterhin kann der Boden der Auffangwanne durch die in das Passepartout eingesetzte Tiegel-Tragplatte gebildet werden.

Bevorzugt wird das Passepartout aus Graphit oder aus einer Kombination von Graphitplatten und/oder Graphitfolien aufgebaut. Auch kann es von Vorteil sein, die Seitenwände der Auffangwanne aus Silizium aufnehmendem Graphitfilz auszubilden.

In der Projektion der horizontalen, geometrischen Schmelzfläche kann in dem Passepartout ein Ausbruch oder Durchbruch als ein Wärmedurchgangsfenster vorgesehen werden.

Um ein Austreten von Schmelze oder Schmelzendämpfen aus dem Inneraum der Vorrichtung zu verhindern, sollten die Spalte, durch das Silizium auslaufen oder austreten kann, in labyrinthartig verlaufenden Stufen ausgeführt werden.

Die Tragstruktur, auf der der Tiegel bzw. die Trageplatte, die den Tiegel trägt, getragen wird, d.h. aufsteht, kann gleichzeitig als Gaszuführung ausgebildet sein. Hierzu wird vorzugsweise mindestens ein Tragbalken vorgesehen, der auf seiner Seite, die dem Tiegelboden zugewandt ist, mit Gasauslassöffnungen, beispielsweise Düsenöffnungen, versehen ist, durch die Kühlgas auf die Unterseite der Bodenplatte des Tiegels bzw. der Trageplatte geführt werden kann. Das erwärmte Kühlgas wird vorzugsweise im Kreislauf über einen Wärmetauscher rückgekühlt und mit einer Pumpe dem Tragbalken wieder zugeführt.

Unterhalb des Tiegelbodens, genauer gesagt unterhalb des Tragbalkens, ist mit Abstand ein unteres, aktives Heizelement sowie eine darunterliegende Kühlplatte mit Kühlschlangen angeordnet, um auch von unten den Tiegel aktiv beheizen und kühlen zu können, insbesondere im Wechselspiel mit dem oberen in der oberen Heizkammer angeordneten Heizelement.

Schließlich können durch die Seitenwände der äußeren Isolierung und die Zwischenisolierung hindurchführende, seitliche Entgasungsöffnungen vorgesehen werden.

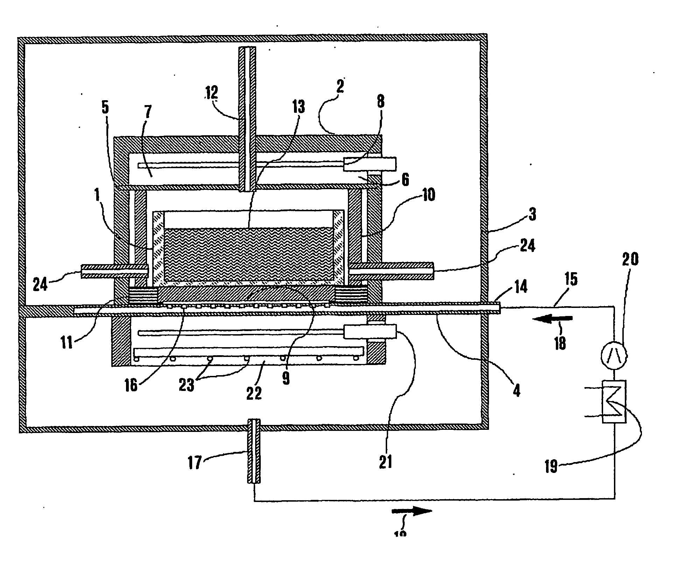

Weitere Einzelheiten und Merkmale der vorliegenden Erfindung ergeben sich aus der nachfolgenden Beschreibung eines Ausführungsbeispiels anhand der Zeichnung, die eine einzige Figur zeigt, in der im Schnitt schematisch eine erfindungsgemäße Vorrichtung dargestellt ist.

Die Vorrichtung, die in der Figur dargestellt ist, dient zum Herstellen gerichtet erstarrter Blöcke aus Halbleitermaterialien, insbesondere aus einer Siliziumschmelze. Die Vorrichtung weist einen Tiegel 1 auf, der von einer äußeren Isolation 2 von oben und von den Seiten umgeben ist. Diese äußere Isolation 2 ist von den Seitenwänden und von der Oberseite des Tiegels 1 beabstandet.

Dieser Tiegel 1 mit äußerer Isolation 2 ist in einer Vakuumkammer 3 angeordnet und ist darin über einen Tragbalken 4, der noch nachfolgend näher beschrieben wird, gehalten.

Oberhalb des Tiegels 1 ist eine Zwischendecke 5 eingezogen, die den oberhalb des Tiegels 1 befindlichen Raum in einen Prozessraum 6 und eine obere Heizkammer 7 unterteilt. In der oberen Heizkammer 7, zwischen der Zwischendecke 5 und dem oberen Abdeckabsteil der Isolation 2, ist ein aktives Heizelement 8, horizontal verlaufend, angeordnet. Die Zwischendecke 5 ist weiterhin auf einer Zwischenisolation 10, einen Rahmen bildend, aufgelegt und abgestützt, die mit Abstand seitlich der Seitenwände des Tiegels 1 einerseits und mit Abstand zu der äußeren Isolation 2 andererseits, jeweils Zwischenräume bildend, angeordnet ist.

Die obere Heizkammer 7 ist gegenüber dem Prozessraum 6 durch die Zwischendecke 5 im wesentlichen gasdicht abgeschlossen.

Der Tiegel 1 ist auf einer Trageplatte 9 getragen, die gleichzeitig die Bodenfläche der äußeren Isolation 2 bildet. Wie in der Figur zu sehen ist, ist die Trageplatte 9 in ein sogenanntes Passepartout 11 eingelegt, das die Trageplatte 9 an ihren Randbereichen gegenüber der Zwischenisolation 10 im wesentlichen gasdicht abdichtet.

Im oberen Bereich der Vorrichtung ist eine rohrförmige Spülgaszuführung 12 vorgesehen, die durch die Zwischendecke 5 und die obere Abdeckung der äußeren Isolation 2 hindurchführt und innerhalb der Vakuumkammer 3 mit ihrem anderen Ende endet.

Die vorstehend erwähnte Zwischenisolation 10 in Verbindung mit dem Passepartout 11 und der Tiegel-Trageplatte 9 dient gleichzeitig als eine Auffangwanne für eventuell aus dem Tiegel 1 auslaufende Schmelze. Das Passepartout 11 kann aus Graphit oder einer Kombination aus Graphitplatten und Graphitfolien, beispielsweise in geeigneter Weise geschichtet, gebildet sein. Die Seitenwände der Auffangwanne, das bedeutet in dem vorliegenden Ausführungsbeispiel die Zwischenisolation 10, können aus einem Silizium aufnehmenden Graphitfilz ausgebildet werden.

Obwohl es nicht näher in der Schnittansicht der Figur zu sehen ist, weist das Passepartout 11, in der Projektion auf die horizontale, geometrische Schmelzfläche, mit dem Bezugszeichen 13 bezeichnet, einen Ausbruch als Wärmedurchgangsfenster auf.

Es sollte darauf hingewiesen werden, dass alle Spalte, durch die Silizium bzw. die in dem Tiegel 1 aufgeschmolzende Schmelze auslaufen kann, in labyrinthartigen Stufen ausgeführt sind, die sich bei ausgelaufener Schmelze von der Wanne aus nacheinander mit Schmelze füllen, die Schmelze durch die abgeführte Wärme zunehmend erstarrt und solche Spalte dann sicher verschließt.

Der Tragbalken 4 ist rohrförmig ausgebildet und dient gleichzeitig als Gaszuführung; hierzu ist das rohrförmige Ende 14 durch die Wand der Vakuumkammer 3 , auf der rechten Seite in der Figur, nach aussen geführt und mit einer Gaszuführleitung 15 verbunden. In der dem Tiegelboden zugewandten Seite des Tragbalkens 4 sind Düsenöffnungen 16 vorhanden, durch die über den rohrförmigen Tragbalken 4 Kühlgas auf die Unterseite der Trageplatte 4, und damit auf die Bodenplatte des Tiegels 1, strömen kann. Das Kühlgas wird im Kreislauf von einem Kühlgasauslass 17, in Richtung der Strömungspfeile 18, über einen Wärmetauscher 19 und eine Kühlgas-Umwälzpumpe 20 zurückgeführt.

Unterhalb des Tragbalkens 4 ist, mit Abstand dazu, ein unteres aktives Heizelement 21 angeordnet. Unterhalb von diesem Heizelement 21 befindet sich eine Kühlplatte 22 mit an der Unterseite angeordneten Kühlschlangen 23, die unter Zuführung eines entsprechenden Kühlfluids ein aktives Kühlen des unteren Bereichs der Anordnung ermöglichen.

Durch das obere Heizelement 8, das untere Heizelement 21, die Gaszuführung über den Tragbalken 4 sowie die untere Kühlplatte 22 kann eine gerichtete Erstarrung der Schmelze erreicht werden, indem Erwärmen und Kühlen entsprechend geführt werden.

Für eine wirkungsvolle Entgasung der Prozesskammer 6 sind im unteren Bereich zwischen den Wänden des Tiegels 1 und der Zwischenisolation 10 Entgasungsöffnungen 24 vorhanden, die in den außen durch die Vakuumkammer 3 begrenzten Raum führen.

## Patentansprüche

1. Verfahren zum Herstellen gerichtet erstarrter Blöcke aus Halbleitermaterialien, wobei die Schmelze, in einem Tiegel aufgenommen, in einem Prozessraum zum gerichteten Erstarren, unter Ausnutzung der Kristallisation, zumindest von der Oberseite aus, erwärmt wird und das Beheizen des Tiegels indirekt von oben über eine obere Heizkammer, die von dem Prozessraum getrennt ist, vorgenommen wird,
**dadurch gekennzeichnet, dass**
die obere Heizkammer gegenüber dem Prozessraum durch eine Zwischendecke im Wesentlichen gasdicht abgeschlossen wird.

2. Verfahren nach Anspruch 1 , **dadurch gekennzeichnet, dass** die obere Heizkammer und der Prozessraum zum gerichteten Erstarren, unter Ausnutzung der Kristallisation, zumindest von der Oberseite aus erwärmt wird.

3. Vorrichtung zum Herstellen gerichtet erstarrter Blöcke aus Halbleitermaterialien, mit einem Tiegel, in dem Schmelze aufgenommen ist, und mit einer den Tiegel zumindest von oben und seitlich umgebenden Isolation, die zumindest oberhalb des Tiegels von diesem beabstandet ist, und mit zumindest einer Heizeinrichtung, die oberhalb des Tiegels angeordnet ist, wobei der Bereich innerhalb der Isolierung (2) oberhalb des Tiegels (1) durch eine Zwischendecke (5) in einen Prozessraum (6) und eine darüber liegende obere Heizkammer (7) unterteilt ist, in der mindestens ein Heizelement (8) angeordnet ist,
**dadurch gekennzeichnet, dass**
die obere Heizkammer (7) gegenüber dem Prozessraum (6) durch die Zwischendecke (5) im wesentlichen gasdicht abgeschlossen ist.

4. Vorrichtung nach Anspruch 3, **dadurch gekennzeichnet, dass** der Tiegel (1) auf einer Trageplatte (9) getragen ist.

5. Vorrichtung nach Anspruch 3 oder 4, **dadurch gekennzeichnet, dass** die Zwischendecke (5) auf einem Rahmen (10) aufliegt, der den Tiegel (1) seitlich mit Abstand umgibt.

6. Vorrichtung nach Anspruch 5, **dadurch gekennzeichnet, dass** der Rahmen aus einem isolierenden Material, Zwischenisolationswände (10) bildend, gebildet ist.

7. Vorrichtung nach einem der Ansprüche 3 bis 6, **dadurch gekennzeichnet, dass** der Rahmen (10) mit Abstand zu der Isolierung (2), einen Zwischenraum bildend, angeordnet ist.

8. Vorrichtung nach Anspruch 4, **dadurch gekennzeichnet, dass** die Tiegel-Tragplatte (9) in ein Passepartout (11) eingesetzt ist.

9. Vorrichtung nach Anspruch 8, **dadurch gekennzeichnet, dass** das Passepartout (11) aus Graphit gebildet ist.

10. Vorrichtung nach Anspruch 8, **dadurch gekennzeichnet, dass** das Passepartout (11) aus einer Kombination von Graphitplatten und/oder Graphitfolien gebildet ist.

11. Vorrichtung nach Anspruch 8, **dadurch gekennzeichnet, dass** die Randbereiche des Passepartouts (11) die Trageplatte (9) gegenüber dem Rahmen (10) im wesentlichen gasdicht abdichten.

12. Vorrichtung nach einem der Ansprüche 3 bis 11, **dadurch gekennzeichnet, dass** eine Spülgaszuführung (12) vorgesehen ist, die von dem oberen Bereich des Prozessraums (6) ausgeht.

13. Vorrichtung nach Anspruch 12, **dadurch gekennzeichnet, dass** die Spülgaszuführung (12) durch die Zwischendecke (5) geführt ist.

14. Vorrichtung nach einem der Ansprüche 3 bis 13, **dadurch gekennzeichnet, dass** der Tiegel (1) mit Isolierung in einer Vakuumkammer (3) angeordnet ist.

15. Vorrichtung nach Anspruch 13 und 14, **dadurch gekennzeichnet, dass** die Spülgaszuführung (12) den Prozessraum (6) direkt mit der Vakuumkammer (3) verbindet.

16. Vorrichtung nach Anspruch 5 und Anspruch 8, **dadurch gekennzeichnet, dass** der Rahmen (10) in Verbindung mit dem Passepartout (11) und der Tiegel-Tragplatte (9) gleichzeitig als Auffangwanne für auslaufende Schmelze ausgebildet ist.

17. Vorrichtung nach Anspruch 16, **dadurch gekennzeichnet, dass** die Seitenwände der Auffangwanne durch den Rahmen (10) gebildet sind.

18. Vorrichtung nach Anspruch 16, **dadurch gekennzeichnet, dass** der Boden der Auffangwanne durch die in das Passepartout (11) eingesetzte Tiegel-Tragplatte (9) gebildet ist.

19. Vorrichtung nach Anspruch 17, **dadurch gekennzeichnet, dass** die Seitenwände der Auffangwanne aus Silizium aufnehmendem Graphitfilz gebildet sind.

20. Vorrichtung nach Anspruch 8, **dadurch gekennzeichnet, dass** das Passepartout (11) in der Projektion der horizontalen, geometrischen Schmelzenfläche (13) einen Ausbruch als Wärmedurchgangsfenster aufweist.

21. Vorrichtung nach einem der Ansprüche 3 bis 20 , **dadurch gekennzeichnet, dass** Spalte, durch die das Silizium auslaufen kann, in labyrinthartigen Stufen ausgeführt sind.

22. Vorrichtung nach einem der Ansprüche 4 bis 21, **dadurch gekennzeichnet, dass** die Tragplatte (9) durch mindestens einen Tragbalken (4) getragen ist.

23. Vorrichtung nach Anspruch 22, **dadurch gekennzeichnet, dass** der Tragbalken (4) gleichzeitig als Gaszuführung (14, 16) ausgebildet ist.

24. Vorrichtung nach Anspruch 23, dadurch gekennzeichet, dass in der dem Tiegelboden zugewandten Seite des Tragbalken (4) Düsenöffnungen (16) angeordnet sind, durch die Kühlgas, über den als Gaszuführung ausgebildeten Tragbalken (4), auf die Unterseite des Tiegelbodens oder der Tiegel-Tragplatte gerichtet wird.

25. Vorrichtung nach Anspruch 24, **dadurch gekennzeichnet, dass** das Kühlgas im Kreislauf über einen Wärmetauscher (19) rückgekühlt und mit einer Pumpe (20) dem Tragbalken (4) zugeführt wird.

26. Vorrichtung nach einem der Ansprüche 4 bis 25, **dadurch gekennzeichnet, dass** unterhalb der Trageplatte (9) des Tiegels (1), mit Abstand dazu, ein unteres aktives Heizelement (21) angeordnet ist.

27. Vorrichtung nach Anspruch 28, **dadurch gekennzeichnet, dass** unterhalb des Heizelement (21) eine Kühleinrichtung (22, 23) angeordnet ist.

## Claims

1. Method for producing oriented solidified blocks made from semiconductor material, wherein the melt, which is received in a crucible, is heated, at least from the top side, in a process chamber for the purpose of oriented solidification, making use of crystallization, and wherein the heating of the crucible is carried out indirectly from above via an upper heating chamber, which is separate from the process chamber,
**characterized in that**
the upper heating chamber is essentially sealed gas-tight against the process chamber by an intermediate cover.

2. The method according to claim 1, **characterized in that** for the purpose of oriented solidification, making use of crystallization, the upper heating chamber and the process chamber are heated at least from the upper side.

3. Device for producing oriented solidified blocks made from semiconductor material, with a crucible, in which the melt is received, and with insulation which surrounds the crucible, at least from the top and from the side, and which is arranged at a distance therefrom, at least above the crucible, and with at least one heating device which is arranged above said crucible (1), wherein the region inside the insulation (2) above the crucible is divided by an intermediate cover (5) into a process chamber (6) and a heating chamber (7) arranged there above, wherein at least one heating element (8) is arranged,
**characterized in that**
the upper heating chamber (7) is essentially sealed gas-tight against the process chamber (6) by the intermediate cover (5).

4. Device according to claim 3, **characterized in that** the crucibles (1) is supported on a plate (9).

5. Device according to one of the claims 3 or 4, **characterized in that** the immediate cover (5) rests on a frame (10) which surrounds the crucible (1) laterally at a distance.

6. Device according to claim 5, **characterized in that** the frame is made from an insulating material, forming intermediate insulating walls (10).

7. Device according to one of the claims 3 to 6, **characterized in that** the frame (10) is arranged at a distance from the insulation (2), fdroming an intermediate space.

8. Device according to claim 4, **characterized in that** the crucible support plate (9) is inserted in a passe-partout (11).

9. Device according to claim 8, **characterized in that** the passe-partout (11) is made from graphite.

10. Device according to claim 8, **characterized in that** the passe-partout (11) is made from a combination of graphite plates and/or graphite sheets.

11. Device according to claim 8, **characterized in that** the marginal areas of the passepartouts (11) essentially seal off the support plate (9) gas-tight from the frame (10).

12. Device according to one of the claims 3 to 11, **characterized in that** a flushing gas feed (12) is provided, which starts from the upper region of the process chamber (6).

13. Device according to claim 12, **characterized in that** the flushing gas supply (12) is guided through the intermediate cover (5).

14. Device according to one of the claims 3 to 13, **characterized in that** the crucibles (1) is arranged with insulation in a vacuum chamber (3).

15. Device according to claim 13 and 14, **characterized in that**, the flushing gas feed (12) directly links the process chamber (6) with the vacuum chamber (3).

16. Device according to claim 5 and claim 8, **characterized in that** the frame (10) in conjunction with the passe-partout (11) and the crucible support plate (9) is simultaneously designed to act as collecting basin for escaping melt.

17. Device according to claim 16, **characterized in that** the side walls of the collecting basin are formed by the frame (10).

18. Device according to claim 16, **characterized in that** the base of the collecting basin is formed by the crucible support plate (9), inserted in the passe-partout (11).

19. Device according to claim 17, **characterized in that** the side walls of the collecting basin are made from silicon-absorbing graphite felt.

20. Device according to claim 8, **characterized in that** the passe-partout (11) has an opening servicing as a heat transfer window in the projection onto the horizontal, geometric melt surface (13).

21. Device according to one of the claims 3 to 20, **characterized in that** the gaps through which silicon could escape are designed as labyrinthine steps.

22. Device after one of the claims 4 to 21, **characterized in that** the support plate (9) is supported by at least one supporting beam (4).

23. Device according to claim 22, **characterized in that** the supporting beam (4) is simultaneous designed as a gas supply line (14, 16).

24. Device according to claim 23, **characterized in that** in the side of the supporting beam (4) facing towards the crucible base, there are arranged nozzle openings (16), through which cooling gas is directed via the supporting beam (4) designed as a gas supply line, to the underside of the crucible base or of the crucible support plate.

25. Device according to claim 24, **characterized in that** the cooling gas is recooled in the circuit by means of a heat exchanger (19) and fed by a pump (20) to the supporting beam (4).

26. Device according to one of the claims 4 to 25, **characterized in that** a lower active heating element (21) is arranged underneath the support plate (9) of the crucible (1), at a distance therefrom.

27. Device according to claim 26, **characterized in that** a cooling device (22, 23) is arranged underneath the heating element (21).

## Revendications

1. Procédé pour fabriquer des blocs solidifiés de manière orientée à partir de matériaux semi-conducteurs, étant précisé que la matière fondue, reçue dans un creuset, est chauffée dans un espace de traitement, au moins par le côté supérieur, en vue de la solidification orientée, à l'aide de la cristallisation, et que le chauffage du creuset est réalisé indirectement par le haut, par l'intermédiaire d'une chambre de chauffe supérieure qui est séparée de l'espace de traitement,
**caractérisé en ce que** la chambre de chauffe supérieure est fermée par rapport à l'espace de traitement de manière globalement étanche au gaz par un recouvrement intermédiaire.

2. Procédé selon la revendication 1, **caractérisé en ce que** la chambre de chauffe supérieure et l'espace de traitement sont chauffés en vue de le solidification orientée, à l'aide de la cristallisation, au moins à partir du côté supérieur.

3. Dispositif pour fabriquer des blocs solidifiés de manière orientée à partir de matériaux semi-conducteurs, avec un creuset dans lequel est reçue de la matière en fusion, et avec une isolation qui entoure le creuset au moins par le haut et latéralement et qui est espacée du creuset au moins au-dessus de celui-ci, et avec au moins un dispositif de chauffe qui est disposé au-dessus du creuset, étant précisé que la zone située à l'intérieur de l'isolation (2) et au-dessus du creuset (1) est divisée par un recouvrement intermédiaire (5) en un espace de traitement supérieur (6) et une chambre de chauffe (7) qui est située au-dessus et dans laquelle est disposé au moins un élément de chauffe (8),
**caractérisé en ce que** la chambre de chauffe supérieure (7) est fermée par rapport à l'espace de traitement (6) de manière globalement étanche au gaz par un recouvrement intermédiaire (5).

4. Dispositif selon la revendication 3, **caractérisé en ce que** le creuset (1) est porté sur une plaque de support (9).

5. Dispositif selon la revendication 3 ou 4, **caractérisé en ce que** le recouvrement intermédiaire (5) est posé sur un cadre (10) qui entoure le creuset (1) latéralement, à une certaine distance.

6. Dispositif selon la revendication 5, **caractérisé en ce que** le cadre se compose d'un matériau isolant qui forme des parois d'isolation intermédiaires (10).

7. Dispositif selon l'une des revendications 3 à 6, **caractérisé en ce que** le cadre (10) est disposé à une certaine distance de l'isolation (2) en formant un espace intermédiaire.

8. Dispositif selon la revendication 4, **caractérisé en ce que** la plaque de support de creuset (9) est insérée dans un passe-partout (11).

9. Dispositif selon la revendication 8, **caractérisé en ce que** le passe-partout (11) est formé à partir de graphite.

10. Dispositif selon la revendication 8, **caractérisé en ce que** le passe-partout (11) est formé à partir d'une combinaison de plaques de graphite et/ou de films de graphite.

11. Dispositif selon la revendication 8, **caractérisé en ce que** les zones du bord du passe-partout (11) rendent la plaque de support (9) globalement étanche au gaz par rapport au cadre (10).

12. Dispositif selon l'une des revendications 3 à 11, **caractérisé en ce qu'**il est prévu une amenée de gaz de lavage (12) qui part de la zone supérieure de l'espace de traitement (6).

13. Dispositif selon la revendication 12, **caractérisé en ce que** l'amenée de gaz de lavage (12) traverse le recouvrement intermédiaire (5).

14. Dispositif selon l'une des revendications 3 à 13, **caractérisé en ce que** le creuset (1) est disposé avec une isolation dans une chambre à vide (3).

15. Dispositif selon les revendications 13 et 14, **caractérisé en ce que** l'amenée de gaz de lavage (12) relie l'espace de traitement (6) directement à la chambre à vide (3) .

16. Dispositif selon la revendication 5 et la revendication 8, **caractérisé en ce que** le cadre (10), conjointement avec le passe-partout (11) et la plaque de support de creuset (9), est conçu en même temps comme un bac collecteur pour la fusion qui s'écoule.

17. Dispositif selon la revendication 16, **caractérisé en ce que** les parois latérales du bac collecteur sont formées par le cadre (10).

18. Dispositif selon la revendication 16, **caractérisé en ce que** le fond du bac collecteur est formé par la plaque de support de creuset (9) insérée dans le passe-partout (11).

19. Dispositif selon la revendication 17, **caractérisé en ce que** les parois latérales du bac collecteur sont formées à partir de feutre de graphite recevant du silicium.

20. Dispositif selon la revendication 8, **caractérisé en ce que** le passe-partout (11), dans la projection de la surface de matière fondue géométrique horizontale (13), présente une percée comme fenêtre de passage de la chaleur.

21. Dispositif selon l'une des revendications 3 à 20, **caractérisé en ce que** des interstices par lesquels le silicium peut s'écouler sont formés par étages labyrinthiques.

22. Dispositif selon l'une des revendications 4 à 21, **caractérisé en ce que** la plaque de support (9) est portée par au moins un support (4).

23. Dispositif selon la revendication 22, **caractérisé en ce que** le support (4) est conçu en même temps comme une amenée de gaz (14, 16).

24. Dispositif selon la revendication 23, **caractérisé en ce que** dans le côté du support (4) tourné vers le fond du creuset sont prévues des ouvertures formant buses (16) par lesquelles un gaz de refroidissement est dirigé vers le côté inférieur du fond du creuset ou de la plaque de support du creuset par l'intermédiaire dudit support (4) conçu comme une amenée de gaz.

25. Dispositif selon la revendication 24, **caractérisé en ce que** le gaz de refroidissement est à nouveau refroidi dans le circuit par un échangeur de chaleur (19) et est amené dans le support (4) à l'aide d'une pompe (20).

26. Dispositif selon l'une des revendications 4 à 25, **caractérisé en ce qu'**un élément de chauffe actif inférieur (21) est disposé au-dessous de la plaque de support (9) du creuset (1), à une certaine distance de celle-ci.

27. Dispositif selon la revendication 26, **caractérisé en ce qu'**un dispositif de refroidissement (22, 23) est disposé au-dessous de l'élément de chauffe (21).
